# EUROPÄISCHE PATENTSCHRIFT

(11) **EP 1 361 581 B1**
(45) Veröffentlichungstag und Bekanntmachung des Hinweises auf die Patenterteilung: **22.03.2006**
(21) Anmeldenummer: 03090102.9
(22) Anmeldetag: 10.04.2003
(51) Int. Cl.: G11C 16/22, G11C 7/24, H01H 71/74, H02H 3/00

(54) **Elektrischer Leistungsschalter mit einem elektronischen Speicher für Kenngrössen und/oder Umrechnungsfaktoren**
Power switch device comprising an electronic memory for characteristics and factors
Disjoncteur avec une mémoire électronique pour le stockage des caractéristiques et des facteurs

(30) Priorität: 08.05.2002 DE 10221571
(43) Veröffentlichungstag der Anmeldung: 12.11.2003
(73) Patentinhaber: SIEMENS AKTIENGESELLSCHAFT, 80333 München (DE)
(72) Erfinder: Driehorn, Thomas, 12249 Berlin (DE); Krauss, Andreas, 10825 Berlin (DE); Musiol, Aron-Ernst, 12305 Berlin (DE); Pancke, Andreas, 13507 Berlin (DE); Redmann, Ilka, 10555 Berlin (DE); Röhl, Wolfgang, 13503 Berlin (DE)

(56) Entgegenhaltungen:
- DE-A- 10 019 092
- US-A- 4 445 198
- US-A- 4 547 853
- US-A- 4 692 903

## Beschreibung

Die Erfindung betrifft einen elektrischen Leistungsschalter mit einer elektronischen Schutzeinrichtung und mit einem von der Schutzeinrichtung räumlich getrennt im Leistungsschalter untergebrachten und mit dieser durch verbundenen elektronischen Speichereinrichtung, die einen mit Anschlüssen zur Versorgung mit einer Betriebsspannung, zur Übertragung von Daten und zur Steuerung einer Schreibschutzeinrichtung ausgestatteten und mittels der Verbindungsleiter von der Schutzeinrichtung lesbaren Speicher für betriebliche Kenngrößen und/oder Umrechnungsfaktoren enthält.

Ein Leistungsschalter dieser Art ist z. B. durch die DE 100 19 092 A1 bekannt geworden. Die in bekannter Weise als elektronischer Überstromauslöser ausgebildete Schutzeinrichtung befindet sich dabei in einem vorderen Bereich des Leistungsschalters hinter einem Bedienpult. Dagegen sind Stromwandler bzw. Stromsensoren, die Messwerte des Stromes in jedem der Pole des Leistungsschalters erfassen und eine zum Betrieb der Schutzeinrichtung benötigte Hilfsenergie bereitstellen, an der dem Bedienpult gegenüberliegenden Rückseite des Leistungsschalters angeordnet. Ein Kabelbaum mit mehreren Verbindungsleitern verbindet diese beiden Bereiche des Leistungsschalters. Der zur Speicherung von der Baugröße und Ausstattung des Leistungsschalters abhängiger Kenngrößen und/oder Umrechnungsfaktoren dienende elektronische Speicher ist in Zuge dieses Kabelbaumes angeordnet.

Eine Speichereinrichtung für die genannten Zwecke kann auch als Informationsspeicher an der Außenseite des Gehäuses der Schutzeinrichtung angeordnet sein (EP 0 847 587 B1 = US 6,034,859).

Ein weitere bekannte Anwendung eines von der Schutzeinrichtung räumlich getrennten elektronischen Speichers ist ein Bemessungsstromstecker nach der US 4,958,252. In diesem Fall dient der Speicher zur Aufzeichnung von betrieblichen Ereignissen, insbesondere Anzahl der Schaltvorgänge und Höhe des jeweils unterbrochenen Stromes, um daraus den Zeitpunkt einer notwendigen Wartung des Leistungsschalters zu ermitteln.

Ist ein elektronischer Speicher der genannten Art von der Schutzeinrichtung räumlich getrennt im Leistungsschalter angeordnet, so wird zur Kommunikation zwischen diesen Einheiten eine Verbindungsleitung oder Kabelbaum benötigt. Dabei kann der elektronische Speicher im Zuge des Kabelbaumes angeordnet sein, wie dies in der erwähnten DE 100 19 092 A1 beschrieben ist. Damit sind alle zusammenwirkenden Bauteile bzw. Einheiten dem störenden Einfluss der in einem Leistungsschalter auftretenden magnetischen, elektrischen und elektromagnetischen Felder ausgesetzt. Da die Empfindlichkeit elektronischer Bauteile und Schaltungen gegen Einflüsse dieser Art bekannt ist, hat man Abschirmungen angebracht, um Störungen in der Funktion der Schutzeinrichtungen zu vermeiden (US 5,303,113).

Die steigenden Anforderungen an das Schaltvermögen von Leistungsschaltern führen allerdings dazu, dass die elektromagnetischen Einflüsse auf alle elektronischen Bauteile eines Leistungsschalters entsprechend zunehmen. Obwohl umfangreiche Erfahrungen in der Beherrschung dieser Einflüsse bestehen, erscheint es im Interesse der Sicherheit erwünscht, die elektromagnetische Verträglichkeit (EMV) insbesondere des gesondert angeordneten elektronischen Speichers zu erhöhen. Dabei steht die Überlegung im Vordergrund, dass bei der Kommunikation zwischen der Schutzeinrichtung und dem Speicher durch ein zufällig stark erhöhtes Störfeld Adressinformationen sowie Schreib- und Leseinformationen verändert werden können. Beispielsweise kann, ohne dass ein Benutzer dies zu erkennen vermag, anstelle eines Lesevorganges ein Schreibvorgang stattfinden. Unter Umständen kann auf diese Weise das Verhalten der Schutzeinrichtung beeinflusst werden, was zu einer unerwünschten Auslösung des Leistungsschalters führen kann oder zu deren Unterdrückung, obwohl sie erforderlich wäre.

An sich liegt es nahe, diese unerwünschten Einflüsse durch die Benutzung des internen Schreibschutzes der elektronischen Speicher auszuschließen. Die Speicherbausteine (EEPROM) verfügen hierzu über einen gesonderten Eingang (WC = WRITE CONTROL), der je nach anliegendem Potential den Schreibschutz aufhebt oder herstellt, wie dies z. B. in der US 5,363,334 beschrieben ist. In einem Leistungsschalter ist jedoch der Speicher nicht zugänglich, z. B. bei der Anordnung im Zuge eines Kabelbaumes nach der DE 100 19 092 A1. Daher lässt sich eine üblicherweise vorgesehene Steckbrücke ("jumper") nicht benutzen. Auch eine elektrische Beschaltung des Schreibschutz-Einganges eines Speichers (EEPROM) stößt auf Schwierigkeiten, weil eine hierzu benötigte zusätzliche Leitung nicht zur Verfügung steht und ihre Nachrüstung einen unerwünschten zusätzlichen Aufwand darstellt.

Der Erfindung liegt hiervon ausgehend die Aufgabe zu Grunde, die Datensicherheit bei der Benutzung eines elektronischen Speichers in einem Leistungsschalter mit möglichst einfachen und dennoch wirksamen Mitteln wesentlich zu verbessern.

Gemäß der Erfindung wird diese Aufgabe dadurch gelöst dass zwischen die zur Versorgung des Speichers mit der Betriebsspannung dienenden Verbindungsleiter und die entsprechenden Anschlüsse des Speichers nahe bei diesem eine Trennschaltung angeordnet ist, welche die über die Verbindungsleiter übertragene Versorgungsspannung in die Betriebsspannung und ein Steuersignal für die Schreibschutzeinrichtung trennt, derart, dass mittels einer Änderung von Eigenschaften der Vorsorgungsspannung bei unveränderter Betriebsspannung des Speichers die Schreibschutzeinrichtung wahlweise aktivierbar oder deaktivierbar ist.

Die genannten Änderungen von Eigenschaften können im Rahmen der Erfindung die Polarität der Leitungsadern bezüglich der Anschlusspunkte des Speichers, die Höhe der Spannung bei unveränderter Polarität und den Wechsel zwischen einer Gleichspannung und einer Rechteckspannung betreffen. Alle diese möglichen Änderungen können mit einfachen Schaltungsmitteln ausgewertet werden.

So eignet sich für das System mit umkehrbarer Polarität einer Gleichspannung eine Trennschaltung, die als wesentliche Komponente eine Gleichrichter-Brückenschaltung aufweist. Bei dem System mit veränderbarer Höhe einer Gleichspannung kann die Trennschaltung eine auf Verdopplung der Spannung ansprechende Schwellwertdiode enthalten. Wird schließlich die Umschaltung einer Gleichspannung in eine Rechteckspannung gewählt, so eignet sich als wesentlicher Bestandteil der Trennschaltung eine Kapazität, die bei anliegender Gleichspannung als Sperre wirkt.

Die Erfindung wird im folgenden anhand der in den Figuren dargestellten Ausführungsbeispiele näher erläutert.

Die Figur 1 zeigt schematisch einen Niederspannungs-Leistungsschalter im Schnitt mit unterschiedlich angeordneten Speichereinrichtungen.

Die Figur 2 zeigt ein Schaltbild einer Speichereinrichtung mit einer auf wechselnde Polarität einer Versorgungsspannung ansprechenden Trennschaltung.

Die Figur 3 zeigt ein Schaltbild einer Speichereinrichtung mit einer auf unterschiedliche Höhe der Versorgungsspannung ansprechenden Trennschaltung.

Die Figur zeigt ein Schaltbild einer Speichereinrichtung mit einer auf die Umschaltung von Gleich- auf Rechteckspannung ansprechenden Trennschaltung.

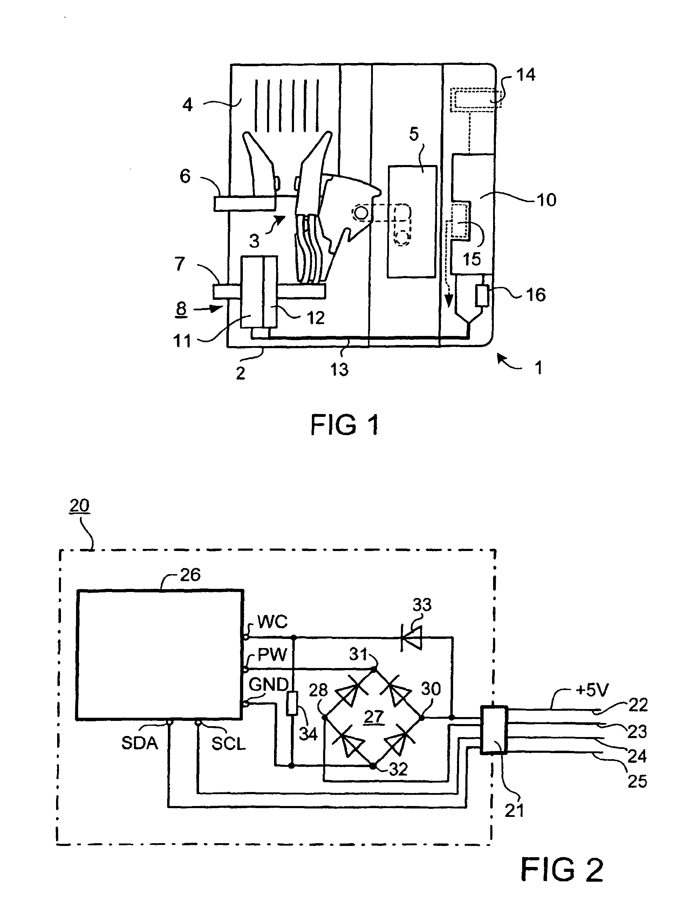

Der in der Figur 1 gezeigte Niederspannungs-Leistungsschalter 1 besitzt in bekannter Weise ein Gehäuse 2, in welchem für jeden Pol eine Schaltkontaktanordnung 3 mit zugehöriger Löschkammer 4 und eine Antriebsvorrichtung 5 zur gemeinsamen Betätigung aller vorhandener Schaltkontaktanordnungen untergebracht sind. Jede der Schaltkontaktanordnungen 3 weist eine obere Anschlussschiene 6 und eine untere Anschlussschiene 7 auf, um den Leistungsschalter 1 mit einem Stromkreis zu verbinden. Jede der unteren Anschlussschienen 7 ist mit einem Wandlersatz 8 versehen, der den über die zugehörige Schaltkontaktanordnung 3 fließenden Strom erfasst und zusätzlich eine Hilfsenergie zum Betrieb einer elektronischen Schutzeinrichtung 10 bereitstellt. Diese kann vorzugsweise als elektronischer Überstromauslöser ausgebildet sein. Jeder Wandlersatz 8 versorgt hierzu die Schutzeinrichtung durch einen Stromwandler 11 mit einem geeigneten Messwert des Stromes und durch einen Energiewandler 12 mit einer benötigten Hilfsenergie.

Die Anschlussschienen 6 und 7 sowie die Wandlersätze 8 befinden sich an der Rückseite des Gehäuses 2, während der als Schutzeinrichtung 10 vorgesehene elektronische Überstromauslöser an der gegenüberliegenden Frontseite des Gehäuses 2 zugänglich ist. Zur Verbindung der Wandlersätze 8 mit der Schutzeinrichtung 10 ist ein Kabelbaum 13 vorgesehen, der in hierzu im Gehäuse 2 vorgesehenen Kanälen verlegt ist, welche die Antriebsvorrichtung 5 und die Schaltkontaktanordnungen 3 umgehen.

Ein ordnungsgemäßes Zusammenwirken der Schutzeinrichtung 10 und der Stromwandler 11 erfordert es, dass die Schutzeinrichtung 10 die ihr zugeführten Stromsignale mit einem Umrechnungsfaktor verarbeitet, der von dem Nennstrom der Stromwandler, der Baugröße des Leistungsschalters und gegebenenfalls weiteren Parametern abhängt. Hierzu ist es bekannt, als Bemessungsstromstecker (Rating Plug), Interface-Modul oder Schalterkennmodul bezeichnete elektrische und/oder elektronische Baugruppen vorzusehen, die nicht in der Schutzeinrichtung 10 selbst angeordnet sind, sondern als periphere Baugruppe mit ihr verbunden sind. Einige der üblichen Anordnungen sind in der Figur 1 angedeutet. Mit 14 ist dabei eine Speichereinrichtung in der gestalt eines Bemessungsstromsteckers etwa nach der DE 100 27 934 A1 oder der US 4,958,252 bezeichnet. Ferner kann eine Speichereinrichtung der genannten .Art als Informationsspeicher nach der EP 0 847 587 B1 (entspricht der US 6,034,859) an der Rückseite der Schutzeinrichtung 10 angeordnet sein, wie dies bei 15 angedeutet ist. Eine weitere Möglichkeit der Anordnung einer Speichereinrichtung ist in der DE 100 19 092 A1 beschrieben, wonach die Speichereinrichtung im Zuge eines die Schutzeinrichtung 10 und den Wandlersatz verbindenden Kabelbaumes bei 16 angeordnet ist. Sind die genannten Speichereinrichtungen mit einem elektrisch löschbaren, programmierbaren nur lesbaren Speicher (EEPROM) ausgestattet, so wird nach der vorliegenden Erfindung durch die Ausnutzung des in den elektronischen Speichern vorhandenen Schreibschutzsystems eine wesentlich verbesserte Datensicherheit erreicht. Einzelheiten dieses Schreibschutzsystems werden nachstehend anhand der Figuren 2, 3 und 4 erläutert.

Die Figur 2 zeigt als erstes Ausführungsbeispiel eine Speichereinrichtung 20, die als Trennschaltung im Sinne der Erfindung eine Gleichrichter-Brückenschaltung 27 aufweist.

Die Speichereinrichtung 20 ist mit einer Anschlussvorrichtung 21 (Buchse für einen Vielfachstecker, Klemmleiste o.ä.) zur Verbindung mit einem Kabelbaum oder dgl. versehen, der vier Verbindungsleiter 22, 23, 24 und 25 enthält. Zu der Speichereinrichtung gehört ein elektronischer Speicher 26, bei dem es sich um ein EEPROM (Electrically Erasable Programmable Read-Only Memory) handelt. Vorzugsweise kann es sich um ein I²C-EEPROM handeln, d. h. das Lesen und Schreiben der Daten erfolgt nach dem Protokoll des bekannten I²C-Bussystems (vgl. http://www.embedded.com/97/feat9711.htm). Hierfür sind die Verbindungsleiter 24 und 25 vorgesehen, die mit den entsprechenden Anschlüssen SDA (Data) und SCL (clock) des Speichers 26 direkt verbunden sind. Die verbleibenden Verbindungsleiter 22 und 23 dienen der Zuführung einer für den Betrieb des Speichers 26 benötigten Hilfsenergie. Diese Leiter sind nicht direkt mit entsprechenden Anschlüssen PW (positives Potential) und GND (Ground) des Speichers 26 verbunden, sondern liegen an den Wechselstrom-Anschlusspunkten 28 und 30 der Gleichrichter-Brückenschaltung 27. Die Anschlüsse PW und GND des Speichers 26 liegen an den Gleichstrom-Anschlusspunkten 31 und 32 der Gleichrichter-Brückenschaltung 27. Daher wird dem Speicher 26 seine Hilfsenergie stets mit der richtigen Polarität zugeführt, unabhängig von der Polarität der Verbindungsleitungen 22 und 23.

Ein bewusst vorgenommener Wechsel der Polarität der Verbindungsleitungen 22 und 23 wird nun dazu benutzt, eine Schreibschutzeinrichtung des Speichers 26 zu aktivieren oder zu deaktivieren. Ein hierzu am Speicher 26 vorgesehener Schreibschutzanschluss WC (Write Control) ist hierzu einerseits durch eine Diode 33 mit der Verbindungsleitung 22 bzw. dem Wechselstrom-Anschlusspunkt 30 der Gleichrichter-Brückenschaltung 27 verbunden und andererseits durch einen Widerstand 34 mit dem Gleichstrom-Anschlusspunkt 32.

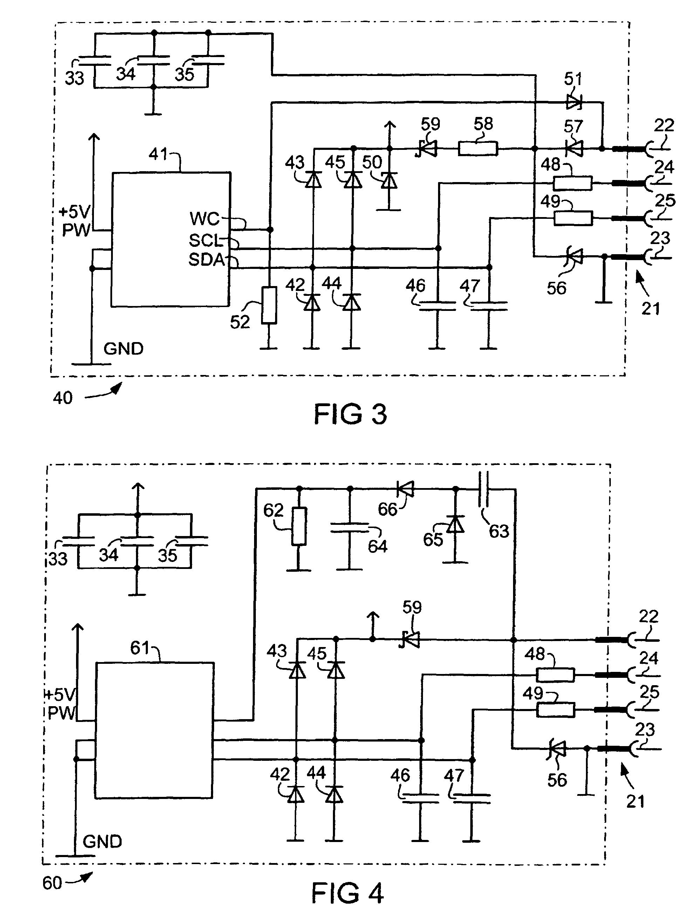

In dem weiteren Ausführungsbeispiel gemäß der Figur 3 weist eine Speichereinrichtung 40 gleichfalls einen elektronischen Speicher 41 der EEPROM-Bauart und eine Anschlussvorrichtung 21 auf, die mit Verbindungsleitern 22, 23, 24 und 25 in Verbindung steht. Die Datenanschlüsse SCL und SCA der Speichers 41 sind durch eine übliche Beschaltung mit Dioden 42, 43, 44 und 45 sowie Kondensatoren 46 und 47 und Widerständen 48 und 49 mit den Verbindungsleitern 24 und 25 verbunden. Über die Verbindungsleitung 22 ist der Speichereinrichtung 40 wahlweise eine Versorgungsspannung der einfachen oder der doppelten Höhe gegenüber der Schaltungsmasse (Verbindungsleitung 23) zuführbar. Eine Z-Diode 50 sorgt für eine gleichbleibende Betriebsspannung des Speicher 41. Eine weitere, am Schreibschutzeingang WC des Speichers 41 liegende Z-Diode 51 bringt den bei einfacher Höhe der Versorgungsspannung über einen Widerstand 52 auf Schaltungsmasse (GND) liegenden Schreibschutzeingang WC auf positives Potential und aktiviert damit den Schreibschutz. Eine Kombination unterschiedlich großer Kondensatoren 53, 54 und 55 dient in Verbindung mit einer Z-Diode 56 zur Aufrechterhaltung der Betriebsspannung des Speichers 41.

Anhand der Figur 4 wird nun ein Ausführungsbeispiel erläutert, in welchem eine Trennschaltung auf eine Umschaltung der Versorgungsspannung von Gleichspannung auf Rechteckspannung reagiert. Die Speichereinrichtung 60 ist wiederum mit einem Speicher 61 und einer Anschlussvorrichtung 21 versehen und weist die gleiche Beschaltung der Datenanschlüsse SCL und SDA durch Dioden 42, 43, 44, 45, Kondensatoren 46 und 47 sowie Widerstände 48 und 49 auf wie in dem Beispiel gemäß der Figur 3. Bei Versorgung mit Gleichspannung liegt der Schreibschutzanschluss WC über einen Widerstand 62 an Schaltungsmasse. Das Beschreiben des Speichers 61 ist damit möglich. Wird dagegen über die Verbindungsleitung 22 eine Rechteckspannung zugeführt, so wirkt ein zwischen die Verbindungsleitung 22 und den Schreibschutzanschluss WC geschalteter Kondensator 63 als endlicher Widerstand, der das Potential von WC auf "high" bringt und dadurch den Speicher gegen Beschreiben sperrt. Dieser Vorgang ist über einen breiten Bereich der Frequenz der Rechteckspannung möglich. Die Bemessung des Kondensators 63 sowie eines weiteren Kondensators 64 in Verbindung mit Dioden 65 und 66 ermöglichen eine geeignete Anpassung der Schaltung. Auch hier ist eine Kombination von Kondensatoren 53, 54 und 55 zur Aufrechterhaltung der Betriebsspannung des Speichers 61 vorgesehen.

### Bezugszeichen

- 1: Leistungsschalter
- 2: Gehäuse des Leistungsschalters
- 3: Schaltkontaktanordnung
- 4: Lichtbogenlöschkammer
- 5: Antriebsvorrichtung
- 6: Obere Anschlussschiene
- 7: Untere Anschlussschiene
- 8: Wandlersatz
- 10: Schutzeinrichtung
- 11: Stromwandler
- 12: Energiewandler
- 13: Kabelbaum
- 14: Elektronische Speichereinrichtung (Rating Plug)
- 15: Elektronische Speichereinrichtung (Informationsspeicher)
- 16: Elektronische Speichereinrichtung (Schalterkennmodul)
- 20: Speichereinrichtung (Figur 2)
- 21: Anschlussvorrichtung
- 22: Verbindungsleiter (Versorgungsspannung)
- 23: Verbindungsleiter (Versorgungsspannung)
- 24: Verbindungsleiter (Daten/Takt)
- 25: Verbindungsleiter (Daten)
- 26: Speicher (EEPROM)
- 27: Gleichrichter-Brückenschaltung
- 28: Wechselstrom-Anschlusspunkt
- 30: Wechselstrom-Anschlusspunkt
- 31: Gleichstrom-Anschlusspunkt
- 32: Gleichstrom-Anschlusspunkt
- 33: Diode für Schreibschutz
- 34: Widerstand für Schreibschutz
- 40: Speichereinrichtung (Figur 3)
- 41: Speicher (EEPROM)
- 42: Diode
- 43: Diode
- 44: Diode
- 45: Diode
- 46: Kondensator
- 47: Kondensator
- 48: Widerstand
- 49: Widerstand
- 50: Z-Diode für Betriebsspannung
- 51: Z-Diode für Schreibschutz
- 52: Widerstand für Schreibschutz
- 53: Kondensator für Betriebsspannung
- 54: Kondensator für Betriebsspannung
- 55: Kondensator für Betriebsspannung
- 56: Z-Diode
- 57: Diode
- 58: Widerstand
- 59: Schottky-Diode
- 60: Speichereinrichtung (Figur 4)
- 61: Speicher (EEPROM)
- 62: Widerstand für Schreibschutz
- 63: Kondensator für Schreibschutz
- 64: Kondensator
- 65: Diode
- 66: Diode

## Patentansprüche

1. Elektrischer Leistungsschalter (1) mit einer elektronischen Schutzeinrichtung (10) und mit einem von der Schutzeinrichtung (10) räumlich getrennt im Leistungsschalter (1) untergebrachten und mit dieser durch Verbindungsleiter (22, 23, 24, 25) verbundenen elektronischen Speichereinrichtung (20; 40; 60), die einen mit Anschlüssen zur Versorgung mit einer Betriebsspannung, zur Übertragung von Daten und zur Steuerung einer Schreibschutzeinrichtung ausgestatteten und mittels der Verbindungsleiter von der Schutzeinrichtung (10) lesbaren Speicher (26; 41; 61) für betriebliche Kenngrößen und/oder Umrechnungsfaktoren enthält,
**dadurch gekennzeichnet,**
**dass** zwischen die zur Versorgung des Speichers (26; 41; 61) mit der Betriebsspannung dienenden Verbindungsleiter (22, 23) und die entsprechenden Anschlüsse des Speichers (PW, GND) nahe bei diesem eine Trennschaltung angeordnet ist, welche die über die Verbindungsleiter (22, 23) übertragene Versorgungsspannung in die Betriebsspannung und ein Steuersignal für die Schreibschutzeinrichtung trennt, derart, dass mittels einer Änderung von Eigenschaften der Vorsorgungsspannung bei unveränderter Betriebsspannung des Speichers (25; 41; 61) die Schreibschutzeinrichtung wahlweise aktivierbar oder deaktivierbar ist.

2. Leistungsschalter nach Anspruch 1,
**dadurch gekennzeichnet,**
**dass** die Versorgungsspannung eine Gleichspannung ist und dass die Änderung in einer Erhöhung bzw. Verringerung der Spannung besteht.

3. Leistungsschalter nach Anspruch 2,
**dadurch gekennzeichnet,**
**dass** zwischen den Anschlusspunkt für die Versorgungsspannung (PW) und den Schreibschutzeingang (WC) des Speichers (41) eine auf Verdoppelung der Versorgungsspannung ansprechende Schwellwertdiode (51) geschaltet ist.

4. Leistungsschalter nach Anspruch 1,
**dadurch gekennzeichnet,**
**dass** die Änderung der Versorgungsspannung in einer Umschaltung von einer Gleichspannung in eine Rechteckspannung besteht.

5. Leistungsschalter nach Anspruch 4,
**dadurch gekennzeichnet,**
**dass** zwischen den Anschlusspunkt (PW) für die Versorgungsspannung und den Schreibschutzeingang (WC) des Speichers (61) eine Kapazität (63) geschaltet ist.

## Claims

1. Electric circuit breaker (1) having an electronic protection device (10) and having an electronic memory device (20; 40; 60) which is accommodated in the circuit breaker (1) such that it is physically separated from the protection device (10), is connected to it by means of connecting conductors (22, 23, 24, 25) and contains a memory (26; 41; 61), which is equipped with connections for supplying it with an operating voltage, for transmitting data and for controlling a write protection device and can be read by the protection device (10) by means of the connecting conductors, for operational characteristics and/or conversion factors, **characterized in that** a dividing circuit is arranged between the connecting conductors (22, 23), used for supplying the memory (26; 41; 61) with the operating voltage, and the corresponding connections of the memory (PW, GND), close to said memory, and divides the supply voltage transmitted via the connecting conductors (22, 23) into the operating voltage and a control signal for the write protection device such that the write protection device can optionally be activated or deactivated by means of a change in properties of the supply voltage with the operating voltage of the memory (26; 41; 61) remaining unchanged.

2. Circuit breaker according to Claim 1, **characterized in that** the supply voltage is a DC voltage, and **in that** the change consists in an increase or a reduction in the voltage.

3. Circuit breaker according to Claim 2, **characterized in that** a threshold value diode (51) which responds to the supply voltage being doubled is connected between the connection point for the supply voltage (PW) and the write protection input (WC) of the memory (41).

4. Circuit breaker according to Claim 1, **characterized in that** the change in the supply voltage consists in a conversion from a DC voltage to a square-wave voltage.

5. Circuit breaker according to Claim 4, **characterized in that** a capacitance (63) is connected between the connection point (PW) for the supply voltage and the write protection input (WC) of the memory (61).

## Revendications

1. Disjoncteur (1) électrique comprenant un dispositif (10) électronique de protection et un dispositif (20 ; 40 ; 60) électronique de mémoire, logé, en étant séparé spatialement du dispositif (10) de protection, dans le disjoncteur (1) et relié à celui-ci par des conducteurs (22, 23, 24, 25) de liaison, qui comportent une mémoire (26 ; 41 ; 61) de grandeurs caractéristiques de fonctionnement et/ou de facteurs de conversion équipée de bornes d'alimentation en une tension de fonctionnement, de transmission de données et de commande d'un dispositif de protection en écriture et pouvant être lue au moyen des conducteurs de liaison par le dispositif (10) de protection,
**caractérisé**
**en ce qu'**il est monté, entre les conducteurs (22, 23) de liaison servant à l'alimentation de la mémoire (26 ; 41 ; 61) en la tension de fonctionnement et les bornes correspondantes de la mémoire (PW, GND) à proximité de cette dernière, un circuit de séparation qui sépare la tension d'alimentation transmise par les conducteurs (22, 23) de liaison en la tension de fonctionnement et en un signal de commande du dispositif de protection en écriture, de façon à pouvoir, au choix, au moyen d'une variation de propriétés de la tension d'alimentation tout en laissant la tension de fonctionnement de la mémoire (26 ; 41 ; 61) inchangée, activer ou désactiver le dispositif de protection en écriture.

2. Disjoncteur suivant la revendication 1,
**caractérisé**
**en ce que** la tension d'alimentation est une tension continue et la modification consiste en une élévation ou en un abaissement de la tension.

3. Disjoncteur suivant la revendication 2,
**caractérisé**
**en ce qu'**il est monté, entre le point de connexion pour la tension (PW) d'alimentation et l'entrée (WC) de protection en écriture de la mémoire (41), une diode (51) à valeur de seuil sensible au double de la tension d'alimentation.

4. Disjoncteur suivant la revendication 1,
**caractérisé**
**en ce que** la modification de la tension d'alimentation consiste en un passage d'une tension continue à une tension rectangulaire.

5. Disjoncteur suivant la revendication 4,
**caractérisé**
**en ce qu'**il est monté, entre le point (PW) de connexion pour la tension d'alimentation et l'entrée (WC) de protection en écriture de la mémoire (61), une capacité (63).
